# EUROPEAN PATENT APPLICATION

(11) **EP 1 610 359 A2**
(43) Date of publication of application: **28.12.2005**
(21) Application number: 05253907.9
(22) Date of filing: 23.06.2005
(51) Int. Cl.: H01L 21/00

(54) **Bonding apparatus, bonding method, and method for manufacturing semiconductor device**

(30) Priority: 24.06.2004 JP 2004186879
(71) Applicant: SHARP KABUSHIKI KAISHA, Osaka-shi, Osaka 545-8522 (JP)
(72) Inventor: Uchida, Kenji, Kasaoka-shi Okayama 714-0044 (JP); Tsukamoto, Hiroaki, Yamatotakada-shi Nara 635-0045 (JP)
(74) Representative: Brown, Kenneth Richard

(57) **Abstract**

A glass piece is peeled from a sheet held on a sheet holding stage by using the suction function of a first suction device and then rested on a glass resting stage. The glass piece is de-electrified by a de-electrifying device during the conveyance of the glass piece to the glass resting stage. The glass piece rested on the glass resting stage is sucked by a second suction device and moved onto a semiconductor wafer whose surface is provided with patterned bonding layers and which is held on a wafer holding stage. The glass piece is placed on the bonding layer and then pressurized, after which the suction function of the second suction device is released. At this time, the glass piece is heated by a heater incorporated in the second suction device.

## Description

### BACKGROUND OF THE INVENTION

The present invention relates to a bonding apparatus which peels a bond substance from a sheet on which bond substances are placed and which bonds the bond substance peeled off to a semiconductor wafer, a bonding method in which the bonding apparatus is used, and a method for manufacturing a semiconductor device through the use of the bonding apparatus and the bonding method.

A technique is disclosed in which damage from flaws or adhesion of dust to the individual image sensors of chips on a semiconductor wafer is prevented by adhering glass so as to cover the image sensors before the separation of the chips (see, for example, Japanese Patent Application Laid-Open No. 3-151666(1991)). In this patent application, however, a method for adhering (bonding) a small piece of glass to individual image sensors is not described.

Also, a technique of bonding individual semiconductor light emitting devices to a semiconductor wafer is disclosed, in which a heater is provided on the side of the semiconductor wafer as a heating mechanism to heat the semiconductor wafer (see, for example, Japanese Patent Application Laid-Open No. 12-164636(2000)). However, the bonding described in this patent application is not adhesive bonding via an adhesive but thermo-compression bonding using bump electrodes.

Furthermore, a technique is disclosed in which a plurality of silicon wafer pieces are bonded to a sheet silicon wafer via a patterned bonding layer (see, for example, Japanese Patent Application Laid-Open No. 8-316496(1996)). In this technique, the silicon wafer pieces are fabricated by giving a dicing cut to the sheet silicon wafer formed on an adhesive sheet, patterning the bonding layer on the silicon wafer, bonding another sheet silicon wafer to the silicon wafer via the bonding layer, and peeling off the adhesive sheet to remove the unnecessary portions of the silicon wafer. However, this technique is not a technique in which individual silicon wafer pieces are bonded one after another.

An effective method of bonding individual small pieces (glass pieces, silicon pieces, etc.) one after another to a semiconductor wafer whose surface is provided with a patterned bonding layer is not described in these patent applications. As an adhesive used for the bonding layer employed in such a bonding (adhesion) method, an adhesive containing a heat-hardenable adhesive is used often in view of ease of handling, so that a method of bonding the small pieces one after another through heating from the side of the semiconductor wafer is thinkable. As for such a method, however, there is the problem that since some portions of the bonding layer harden before the bonding (adhesion), the small pieces cannot be bonded to those portions. Besides, since the use of the small pieces to which dust adheres may cause defective semiconductor wafers and semiconductor devices, measures against the dust adhering to the small pieces are called for at the step of bonding the small places; however, effective measures are not yet proposed.

### BRIEF SUMMARY OF THE INVENTION

In light of the conventional art problems, the present invention is directed to solve the problems with the various bonding techniques. That is, an object of the invention is to provide a bonding apparatus capable of efficiently bonding (adhering) a bond substance to a semiconductor wafer.

Another object of the invention is to provide a bonding apparatus with which the occurrence of bonding (adhesion) defects can be suppressed and with which the bonding (adhesion) of the bond substances to individual bonding layers can be performed reliably through heating from the side of the bond substances instead of the side of the semiconductor wafer even when the semiconductor wafer is provided with the bonding layers containing a heat-hardenable adhesive in advance, a bonding method in which the bonding apparatus is used, and a method for manufacturing a semiconductor device using the bonding apparatus.

Still another object of the invention is to provide a bonding apparatus capable of suppressing the occurrence of problems such as adhesion of dust and element breakdown caused by the electrification of the bond substance through the de-electrification of the sucked bond substance, that is, the elimination of the electric charge resulting from the peeling of the bond substance from a sheet, a bonding method in which the bonding apparatus is used, and a method for manufacturing a semiconductor device using the bonding apparatus.

The bonding apparatus according to the invention is provided with a first holding unit which holds a semiconductor wafer, a second holding unit which holds a sheet on which a plurality of bond substances are placed, and a suction unit which sucks the bond substance from the sheet held by the second holding unit and which places the bond substance onto the semiconductor wafer held by the first holding unit. The bond substance is sucked from the sheet held by the second holding unit and is placed onto the semiconductor wafer held by the first holding unit. As a result, the bond substance can be bonded (adhered) to the semiconductor wafer efficiently.

The bonding apparatus according to the invention is provided with a heating unit which heats the bond substance sucked by the suction unit. Through the use of the heating unit, the bond substance sucked by the suction unit is heated. At this time, the semiconductor wafer is not heated, but the bond substance to be bonded (adhered) is heated. Because of this, the heat-hardenable adhesive-containing bonding layers provided on the semiconductor wafer are not hardened before the bonding (adhesion), so that bonding (adhesion) defects do not occur easily. Naturally, the bonding layers to be bonded (adhered) are hardened by the heat from the bond substance, so that it is possible to achieve bonding (adhesion) reliably. Since the heating is conducted from the side of the bond substance, even when the semiconductor wafer is provided with the bonding layers containing the heat-hardenable adhesive in advance, the occurrence of bonding (adhesion) defects can be suppressed, thereby the bonding (adhesion) of the bond substance to the individual bonding layers can be performed reliably.

With the bonding apparatus according to the invention, the suction unit has the heating unit. The bond substance is heated by the heating unit incorporated in the suction unit. Because of this, the heating can be conducted by using the suction unit, so that the heating is conducted efficiently.

The bonding apparatus according to the invention is provided with a de-electrifying unit which de-electrifies the bond substance by the suction unit. When the bond substance by the suction unit is de-electrified, the electric charge of the bond substance caused by its peeling from the sheet is eliminated, thereby the occurrence of problems such as adhesion of dust and element breakdown caused by the electrification is suppressed.

As the suction unit, the bonding apparatus according to the invention includes the first suction device which sucks the bond substance from the sheet held by the second holding unit and which places it onto an intermediate stage, and the second suction device which sucks the bond substance placed on the intermediate stage and which places it onto the semiconductor wafer held by the first holding unit. The unit used for performing the process step of peeling the bond substance from the sheet through the use of its suction function (the first suction unit) and the unit used for performing the process step of placing the bond substance peeled off onto the semiconductor wafer through the use of its suction function (the second suction unit) are provided separately. Therefore, since the process step of peeling the bond substance from the sheet through the use of the suction function and the process step of placing the bond substance peeled off onto the semiconductor wafer through the use of the section function can be performed concurrently, it is possible for the individual process steps to overlap each other, thereby the efficiency of the processing is improved.

With the bonding apparatus according to the invention, the second suction device has the heating unit used for heating the bond substances suctioned. The bond substance is heated by the heating unit incorporated in the unit (the second suction unit) used for performing the process step of placing the bond substance onto the semiconductor wafer; hence, the heating can be conducted by the suction unit, so that the heating is conducted efficiently.

With a bonding method according to the invention, the bond substance placed on the sheet is peeled from the sheet, and then it is bonded to the semiconductor wafer with the bond substance heated from its own side. Since the heating is not conducted from the side of the semiconductor wafer but conducted from the side of the bond substance to be bonded (adhered) which has been peeled from the sheet, the heat-hardenable adhesive-containing bonding layers provided on the semiconductor wafer are not hardened before the bonding (adhesion), so that bonding (adhesion) defects do not occur easily. Naturally, the bonding layers to be bonded (adhered) are hardened due to the heat from the bond substance, so that the bonding (adhesion) can be achieved reliably. Since the heating is conducted from the side of the bond substance, even when the semiconductor wafer is provided with the bonding layers containing the heat-hardenable adhesive in advance, it is possible to suppress the occurrence of the bonding (adhesion) defects, thereby the bonding (adhesion) of the bond substance to the individual bonding layers can be performed reliably.

In the bonding method according to the invention, the suction unit is used when the bond substance is peeled from the sheet, and the bond substance is heated by the suction unit to be bonded to the semiconductor wafer. Since the bond substance is peeled from the sheet through the use of the suction function of the suction unit, the peeling step can be performed efficiently. Besides, since the bond substance is heated by the heating unit incorporated in the suction unit, the heating can be conducted by using the suction unit, so that the heating is conducted efficiently.

In the bonding method according to the invention, the bond substance peeled from the sheet is de-electrified. Therefore the electric charge of the bond substance caused by its peeling from the sheet is eliminated, so that the occurrence of problems, such as adhesion of dust and element breakdown caused by the electrification, is suppressed.

A method for manufacturing a semiconductor device according to the invention is as follows: bond substances are bonded to a semiconductor wafer through the use of the bonding method, and then the semiconductor wafer is cut into individual semiconductor devices. As a result, any one of the occurrence of bonding (adhesion) defects and the occurrence of the problems caused by the electrification of the bond substances or both are suppressed significantly, so that the yield of the semiconductor devices is improved.

The above and further objects and features of the invention will more fully be apparent from the following detailed description with accompanying drawings.

### BRIEF DESCRIPTION OF THE SEVERAL VIEWS OF THE DRAWINGS

FIG. 1 is a schematic diagram of an exemplary bonding apparatus according to the invention;
FIG. 2 is a cross-sectional view of an exemplary semiconductor wafer held on a wafer holding stage;
FIG. 3 is a cross-sectional view of an exemplary sheet which is held on a sheet holding stage and on which a plurality of glasses are placed;
FIGS. 4A and 4B are process drawings of an exemplary bonding method according to the invention;
FIGS. 5A to 5D are process drawings of an exemplary bonding method according to the invention; and
FIG. 6 is a schematic diagram of another exemplary bonding apparatus according to the invention.

### DETAILED DESCRIPTION OF THE INVENTION

The present invention will be specifically described below with reference to the drawings showing embodiments thereof. In the following embodiments, cases where glass pieces are used as bond substances will be explained. It is to be understood that the invention is not limited to the following embodiments unless otherwise the invention departs from the appended claims.

### <FIRST EMBODIMENT>

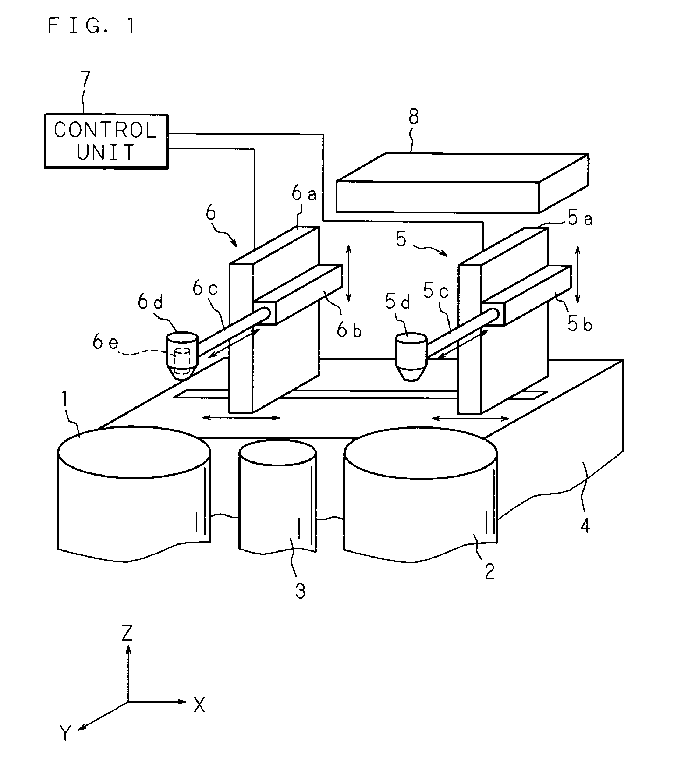

FIG. 1 is a schematic diagram an exemplary bonding apparatus according to the invention. The bonding apparatus is equipped with a wafer holding stage 1 serving as a first holding unit which holds a semiconductor wafer, a sheet holding stage 2 serving as a second holding unit which holds a sheet on which a plurality of glass pieces (bond substances) are placed, and a glass resting stage 3 provided between the wafer holding stage 1 and the sheet holding stage 2 and serving as an intermediate stage on which the glasses sucked from the sheet are rested temporarily.

Also, a rectangular base 4 is provided whose direction of the length is parallel to the direction of the arrangement of the wafer holding stage 1, the sheet holding stage 2, and the glass resting stages 3 (the direction of the X axis shown in FIG. 1). On the base 4 on the side of the sheet holding stage 2, a first suction device 5 is provided which sucks the glass from the sheet held on the sheet holding stage 2 and which conveys the glass to the glass resting stage 3. On the base 4 on the side of the wafer holding stage 1, a second suction device 6 is provided which sucks the glass rested on the glass resting stage 3 and which places the glass onto the semiconductor wafer held on the wafer holding stage 1.

The first suction device 5 has a cuboid pickup-head X-axial moving unit 5a, a cuboid pickup-head Z-axial moving unit 5b provided on a side of the pickup-head X-axial moving unit 5a, a cylindrical pickup-head Y-axial moving unit 5c provided so as to be exposed from an end surface of the pickup-head Z-axial moving unit 5b, and a pickup head 5d attached to the end of the pickup-head Y-axial moving unit 5c and serving as a suction member having a suction function. The pickup-head X-axial moving unit 5a is movable in the direction of the X axis, the pickup-head Z-axial moving unit 5b is movable in the direction of the Z axis, and the pickup-head Y-axial moving unit 5c is movable in the direction of the Y axis. The control of the movements of these pickup-head moving units 5a, 5b, and 5c makes it possible to freely position the pickup head 5d in its three-dimensional direction. As with the first suction device 5, the second suction device 6 has a bonding head X-axial moving unit 6a movable in the direction of the X axis, a bonding head Z-axial moving unit 6b movable in the direction of the Z axis, a bonding head Y-axial moving unit 6c movable in the direction of the Y axis, and a bonding head 6d serving as a suction member capable of being freely positioned in the three-dimensional direction. The movements of the individual moving units are controlled by control signals from a control unit 7.

As for the pickup head 5d of the first suction device 5 and the bonding head 6d of the second suction device 6, a suction path (not shown) is formed inside, so that the glass can be sucked by vacuum suction. The bonding head 6d of the second suction device 6 incorporates a heater 6e having a heating function to heat the sucked glass. In contrast, the pickup head 5d of the first suction device 5 is not provided with such a heater.

Above an area into which the pickup head 5d of the first suction device 5 is movable, a de-electrifying unit (ionizer) 8 is provided which de-electrifies the glass by the first suction device 5. The de-electrifying unit 8 performs de-electrification process by blasting an ionized gas to the glass.

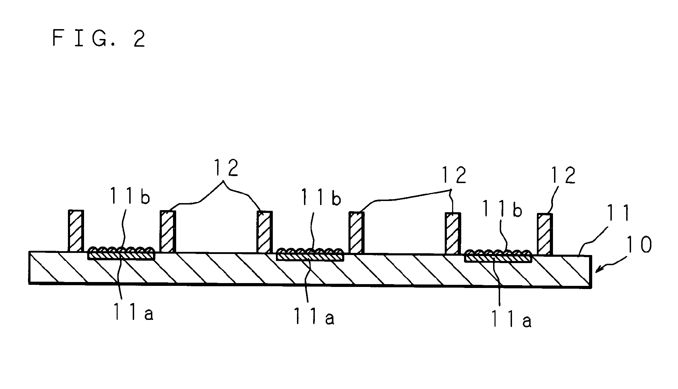

FIG. 2 is a cross-sectional view of an exemplary semiconductor wafer 10 held on the wafer holding stage 1. The semiconductor wafer 10 has a structure in which a plurality of light-receiving portions 11a and microlenses 11b are patterned on one surface of a semiconductor substrate 11 and in which a plurality of bonding layers 12 are patterned in regions other than regions where the light-receiving portions 11a and the microlenses 11b are formed. To hold the semiconductor wafer 10 on the wafer holding stage 1, vacuum suction can be used.

The bonding layers 12 undoubtedly contain a heat-hardenable adhesive which develops adhesivity through heating. As for the patterning of the bonding layers 12, the layers 12 can be pattern-printed by using screen printing or the like, while in the embodiments of the invention, the bonding layers 12 are patterned in a photolithographic process (exposure and development) using a mixture of the hest-hardenable adhesive and a photosensitive adhesive (photo-hardenable adhesive) which develops adhesivity through photoirradiation so as to allow finer patterning.

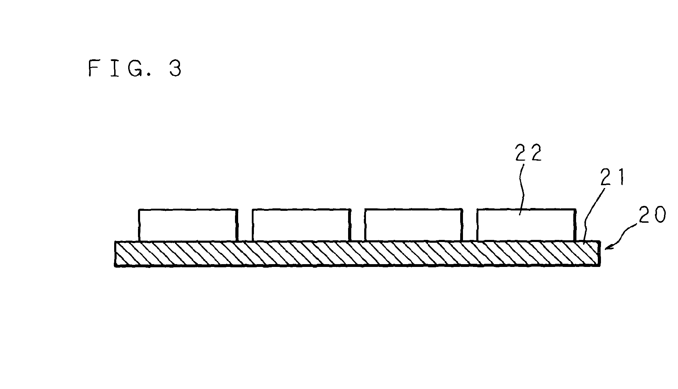

FIG. 3 is a cross-sectional view of an exemplary sheet 20 which is held on the sheet holding stage 2 and on which the glasses are placed. The sheet 20 has a structure in which the glasses 22 are adhered to one surface of an adhesive sheet 21. Such glasses 22 are fabricated by cutting a glass sheet adhered to the adhesive sheet 21 into glass pieces. Although not shown in the drawings, the adhesive sheet 21 is supported by a ring-shaped frame body at its perimeter, and the ring-shaped frame body is clamp-held by the sheet holding stage 2.

As the adhesive sheet 21, it is possible to use an adhesive sheet whose adhesivity is degraded by photoirradiation such as ultraviolet irradiation. When such an ultraviolet sheet is used, it is preferable that the adhesivity of the adhesive sheet 21 be degraded in advance by conducting photoirradiation before the peeling of the glasses 22 so as to make it possible to peel off the glasses 22 easily. Although described later in more detail, the glasses 22 are placed so as to cover the light receiving portions 11a shown in FIG. 2 and function as translucent coverings for a solid-state imaging device.

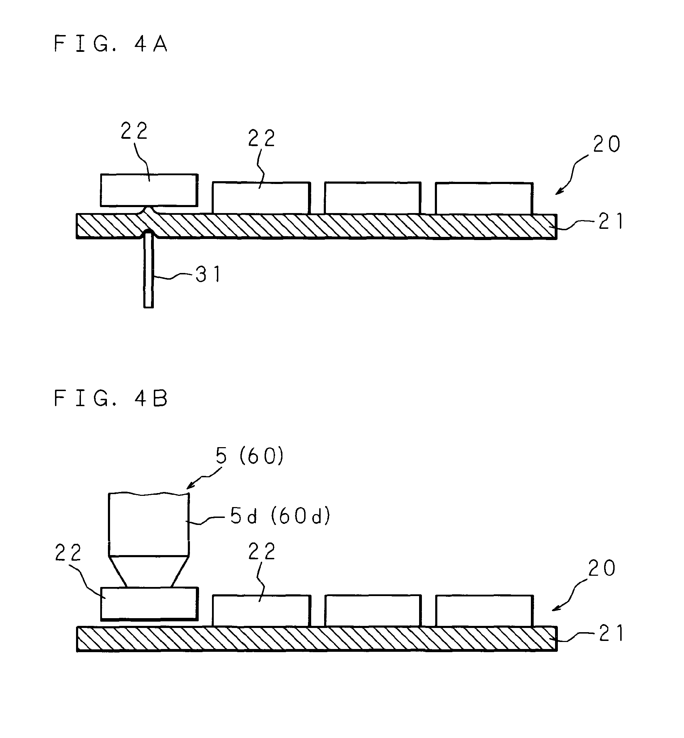

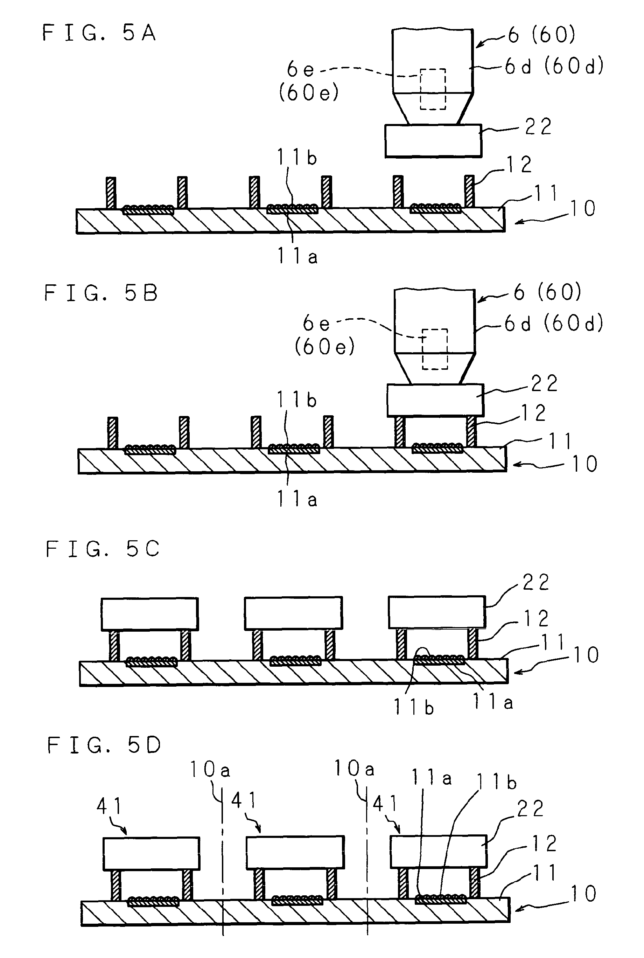

Next, a bonding method using the bonding apparatus having the structure described above will be explained with reference to FIGS. 4A, 4B, and 5A to 5D.

As for processing steps performed on the sheet 20 held on the sheet holding stage 2, the underside of the adhesive sheet 21 immediately underneath the glass 22 to be peeled off is pushed up with a pin 31 into a state in which the glass 22 is partly peeled from the adhesive sheet 21 (see FIG. 4A), after which the glass 22 is sucked up with the first suction device 5 (pickup head 5d) to be completely peeled from the adhesive sheet 21 (see FIG. 4B). While sucked up with the first suction device 5, the glass 22 peeled off is conveyed to the glass resting stage 3, and then the glass 22 is rested on the glass resting stage 3.

At such a peeling step, the glass 22 becomes charged. The glass 22 is an electrical insulator, and there is a tendency for dust, such as glass swarf produced during the cutting of the glass sheet, to adhere to the piece of glass 22. When the glass 22 to which the dust has adhered is used for the fabrication of optical semiconductor devices such as solid-state imaging devices, the dust may become a cause of their defectiveness; hence, it is necessary to suppress the adhesion of the dust to the glass 22. In this embodiment of the invention, the glass 22 sucked up with the first suction device 5 is de-electrified by the de-electrifying unit 8. Since the de-electrification processing suppresses the adhesion of the dust to the glass 22, semiconductor devices using the glasses 22 offer a significant decrease in the occurrence of defectives.

The glass 22 rested on the glass resting stage 3 is sucked up with the second suction device 6 (bonding head 6d), and then the second suction device 6 sucking up the glass 22 is moved above the semiconductor wafer 10 on which the bonding layers 12 are patterned (see FIG. 5A). The glass 22 is positioned in advance for the purpose of being adhered to the semiconductor substrate 11 via the bonding layers 12, following which the second suction device 6 (bonding head 6d) descends to place the glass 22 onto the bonding layers 12. After the application of pressure to the glass 22, the suction function of the second suction device 6 (bonding head 6d) is deactivated (see FIG. 5B).

At that time, the glass 22 is heated with the heater 6e incorporated in the second suction device 6 (bonding head 6d). A temperature at which the glass 22 is heated is set so that the heat-hardenable adhesive of the bonding layer 12 develops its adhesivity with heat transfer through the medium of the glass 22, which allows the glass 22 to adhere to the semiconductor substrate 11 via the bonding layer 12. According to the invention, such a heating through which the heat-hardenable adhesive of the bonding layer 12 develops its adhesivity is not conducted from the side of the semiconductor wafer 10. Therefore the heat is less easily transferred to the bonding layers 12 on which the glass 22 is not yet placed, so that the bonding layers 12 other than the bonding layers 12 to be adhered which have already been heated and pressurized by the second suction device 6 do not harden. In this embodiment of the invention, although sufficient adhesion of the glasses 22 to the bonding layers 12 cannot be attained, the glasses 22 are temporarily adhered to the extent that they do not peel off in subsequent steps in view of time taken for the manufacturing process of semiconductor devices etc.

By repeating such an operation, the semiconductor wafer 10 provided with the glasses 22 adhered to the semiconductor substrate 11 is fabricated (see FIG. 5C). Since the bonding layers 12 reach a temperature at which they develops their adhesivity only when they come in contact with the glasses 22 sucked up by the second suction device 6 (bonding head 6d), the bonding (adhesion) of the individual glasses 22 can be conducted reliably.

In this embodiment of the invention, since the step of peeling the glass 22 from the sheet 20 through the use of the first suction device 5 and the step of placing the glass 22 peeled off onto the semiconductor wafer 10 through the use of the second suction device 6 can be performed concurrently, the operation efficiency of the bonding apparatus is improved.

After the adhesion (tack bonding) of the glasses 22 to the necessary places of the semiconductor substrate 11 has been completed, the semiconductor wafer 10 is removed from the wafer holding stage 1 and put into a heating apparatus (oven), following which the semiconductor wafer 10 is heated at a predetermined temperature to harden the bonding layers 12 completely (final hardening).

Then the semiconductor wafer 10 thus fabricated is cut along parting lines 10a into individual pieces by using a dicing apparatus etc., thereby a semiconductor device (in this embodiment, a solid-state imaging device 41) having the semiconductor substrate 11 to which the glass 22 is bonded is fabricated (see FIG. 5D).

### <SECOND EMBODIMENT>

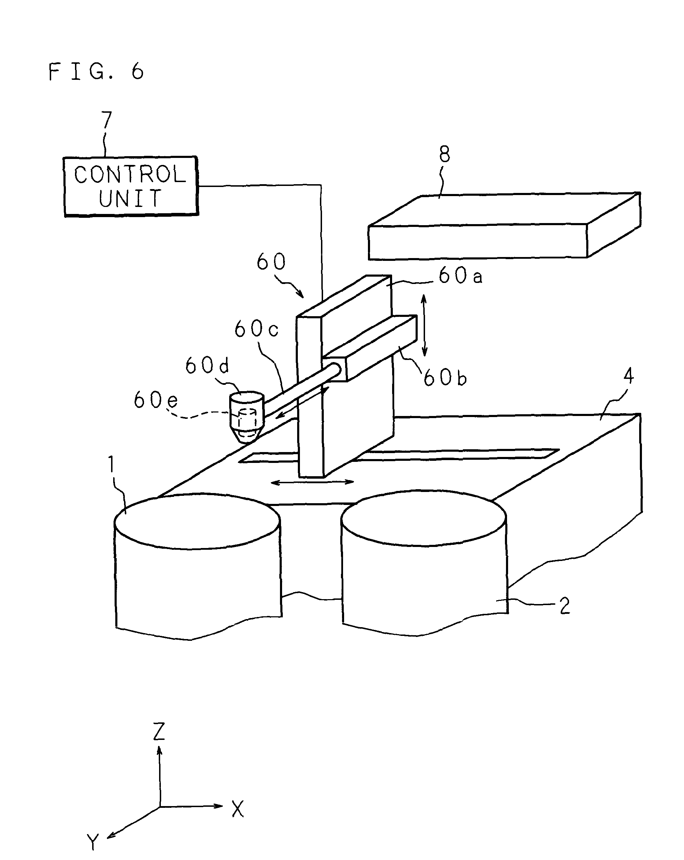

FIG. 6 is a schematic diagram of another exemplary bonding apparatus according to the invention. In FIG. 6, the same components as those shown in FIG. 1 are given the same reference numerals. The bonding apparatus according to the second embodiment is provided with the same wafer holding stage 1 and sheet holding stage 2 as those described in the first embodiment but not provided with the glass resting stage 3.

Also, unlike the first embodiment, the bonding apparatus according to the second embodiment has a suction device 60 on the base 4. The suction device 60 has the same structure as that of the second suction device 6 described in the first embodiment; that is, the suction device 60 has a suction head X-axial moving unit 60a which is movable in the direction of the X axis, a suction head Z-axial moving unit 60b which is movable in the direction of the Z axis, a suction head Y-axial moving unit 60c which is movable in the direction of the Y axis, and a suction head 60d serving as a suction member which can be freely positioned in the three-dimensional direction and which incorporates a heater 60e. The suction device 60 successively conducts the two processings conducted by the first suction device 5 and the second suction device 6 described in the first embodiment; that is, the suction device 60 sucks up the glass from the sheet held on the sheet holding stage 2 and places the glass onto the semiconductor wafer held on the wafer holding stage 1. The three-dimensional position of the suction device 60 (suction head 60d) is controlled with the control unit 7. Besides, like the bonding apparatus according to the first embodiment, the de-electrifying unit 8 is provided above an area where the suction head 60d of the suction device 60 is movable.

Both structures of the semiconductor wafer 10 held on the wafer holding stage 1 and the sheet 20 held on the sheet holding stage 2 are the same as those described in the first embodiment (see FIGS. 2 and 3).

Next, a bonding method in which the bonding apparatus having such a structure is used will be described.

As for processing steps performed on the sheet 20 held on the sheet holding stage 2, the underside of the adhesive sheet 21 immediately underneath the glass 22 to be peeled off is pushed up with the pin 31 into a state in which the glass 22 is partly peeled from the adhesive sheet 21 (see FIG. 4A), after which the glass 22 is sucked up with the suction device 60 (suction head 60d) to be completely peeled from the adhesive sheet 21 (see FIG. 4B). At this time, a heating step at which the heater 60e is used is not performed. This is because not only heating is not required particularly, but the adhesive sheet 21 is of low heat resistance.

While the glass 22 is being conveyed to the wafer holding stage 1 with the glass 22 sucked up by the suction device 60 (suction head 60d), the glass 22 is de-electrified by the de-electrifying unit 8 as is the case with the first embodiment. Through the de-electrification process, the adhesion of dust to the glass 22 is suppressed, so that the occurrence of defectives is significantly reduced among the semiconductor devices including the glasses 22.

The suction device 60 sucking up the glass 22 is moved to above the semiconductor wafer 10 (see FIG. 5A), and then the glass 22 is positioned in advance so as to be bonded to the semiconductor substrate 11 via the bonding layers 12, after which the suction head 60d is moved down to place the glass 22 onto the bonding layers 12, the glass 22 is pressurized, and the suction function of the suction head 60d is released (see FIG. 5B).

At this time, as is the case with the first embodiment, the glass 22 is heated with the heater 60e incorporated in the suction device 60 (suction head 60d) instead of heating from the side of the semiconductor wafer 10. Through the heating, the bonding layer 12 is hardened into a state of tacking. By repeating such an operation, the semiconductor wafer 10 having the semiconductor substrate 11 to which the glasses 22 are bonded is fabricated (see FIG. 5C). Thereafter, as is the case with the first embodiment, the bonding layers 12 are finally hardened with a heating apparatus, after which the semiconductor wafer 10 is cut into individual pieces, thereby semiconductor devices (in this embodiment, the solid-state imaging devices 41) are fabricated (see FIG. 5D).

In the second embodiment of the invention, since the glass resting stage 3 is not provided, and only the suction device 60 is provided, it is possible to make the bonding apparatus small when compared with that described in the first embodiment.

In the embodiments of the invention, the first suction device 5, the second suction device 6, and the suction device 60 have the one suction member (the pickup head 5d, the bonding head 6d, and the suction head 60d) respectively, while the individual suction devices may have a plurality of suction members; in that case, the suction members of the second suction device 6 and the suction device 60 should have a heater used for heating respectively. Through the use of these additional components, the processing of the glasses 22 can be conducted concurrently, thereby operation efficiency is improved.

Also, in the embodiments of the invention, the positioning of the individual suction members to the semiconductor wafer and the sheet is conducted by the control of the three-dimensional position of the suction members through the fixation of the wafer holding stage 1, the sheet holding stage 2, and the glass resting stage 3 and through the movement of the three moving units of the individual suction devices, while the positioning may be conducted by the movement of the wafer holding stage 1, the sheet holding stage 2, and the glass resting stage 3 in one or plural directions; for instance, in FIGS. 1 and 6, it is possible to employ a structure in which the wafer holding stage 1, the sheet holding stage 2, and the glass resting stage 3 can be moved in the direction of the Y axis, and the head Y-axial moving units 5c, 6c, and 60c are fixed.

Besides, in the embodiments of the invention, the suction devices (suction members) are provided with such a heating function, while a suction device (suction member) having no heating function may be used to place the glass onto the semiconductor wafer, and then a heating and pressure unit having no suction function may be used to heat and pressurize the glass.

Further, in the embodiments of the invention, cases where the bonding layers are formed on the semiconductor wafer have been described, while a case where the bonding layers are formed on the glass also produces the same effect as that described in the embodiments of the invention.

Still further, in the embodiments of the invention, cases where the solid-state imaging devices are manufactured have been described, while the invention is also applicable to the manufacture of any other kind of semiconductor devices, such as semiconductor memory including EPROM, so long as they are provided with a light-receiving unit having a translucent cover made of glass. In addition, the translucent cover described in the embodiments of the invention is made of glass, while resin material or the like may be used.

The invention is also applicable to a case where other kinds of semiconductor devices are manufactured by using semiconductor chips instead of the glass as the bond substances. In that case, bonding layers containing an electrically conductive adhesive may be used to establish electric connections.

## Claims

1. A bonding apparatus **characterized by** comprising:
a first holding unit (1) which holds a semiconductor wafer (10);
a second holding unit (2) which holds a sheet (20) on which a plurality of bond substances (22) are placed; and
a suction unit (5, 6, 60) which sucks the bond substance (22) from the sheet (20) held by the second holding unit (2) and which places the bond substance (22) onto the semiconductor wafer (10) held by the first holding unit (1).

2. The bonding apparatus according to claim 1 further comprising a heating unit (6e, 60e) which heats the bond substance (22) sucked by the suction unit (5, 6, 60).

3. The bonding apparatus according to claim 2, wherein the suction unit (6, 60) has the heating unit (6e, 60e).

4. The bonding apparatus according to any one of claims 1 to 3 further comprising a de-electrifying unit (8) which de-electrifies the bond substance (22) sucked by the suction unit (5, 6, 60).

5. The bonding apparatus according to any one of claims 1 to 4, wherein the suction unit (5, 6) includes a first suction device (5) which sucks the bond substance (22) from the sheet (20) held by the second holding unit (2) and which rests the bond substance (22) onto an intermediate stage (3), and a second suction device (6) which sucks the bond substance (22) rested on the intermediate stage (3) and which places the bond substance (22) onto the semiconductor wafer (10) held by the first holding unit (1).

6. The bonding apparatus according to claim 5, wherein the second suction device (6) has a heating unit (6e) which heats the sucked bond substance (22).

7. A bonding method **characterized by** comprising the steps of:
peeling a bond substance (22) from a sheet (20) on which the bond substances (22) are placed; and
bonding the bond substance (22) peeled off to a semiconductor wafer (10) with the bond substance (22) heated from the side of the substance (22) itself.

8. The bonding method according to claim 7, wherein the bond substance (22) is peeled from the sheet (20) by using a suction unit (5, 6, 60) and is heated by the suction unit (5, 6, 60) to be bonded to a semiconductor wafer (10).

9. The bonding method according to either claim 7 or claim 8, wherein the bond substance (22) peeled from the sheet (20) is de-electrified.

10. A method for manufacturing a semiconductor device **characterized by** comprising the steps of:
bonding the bond substances (22) to a semiconductor wafer (10) through the use of the bonding method according to any one of claims 7 to 9; and
cutting the semiconductor wafer (10) into individual semiconductor devices (41).
